# EUROPEAN PATENT APPLICATION

(11) **EP 4 318 579 A1**
(43) Date of publication of application: **07.02.2024**
(21) Application number: 23176199.0
(22) Date of filing: 30.05.2023
(51) Int. Cl.: H01L 23/498, H01L 23/538

(54) **SEMICONDUCTOR PACKAGE**

(30) Priority: 04.08.2022 KR 20220097564; 24.10.2022 KR 20220137589
(71) Applicant: Samsung Electronics Co., Ltd., Suwon-si, Gyeonggi-do 16677 (KR)
(72) Inventor: PARK, Jongho, 16677 Suwon-si (KR); KANG, Gyuho, 16677 Suwon-si (KR); PARK, Sung Keun, 16677 Suwon-si (KR); BAE, Seong-Hoon, 16677 Suwon-si (KR); JUNG, Jaemok, 16677 Suwon-si (KR); CHOI, Ju-Il, 16677 Suwon-si (KR)
(74) Representative: Marks & Clerk LLP

(57) **Abstract**

A semiconductor package includes a first substrate, a semiconductor chip on the first substrate, a second substrate spaced apart from the first substrate , a wire spaced apart from a lateral surface of the semiconductor chip and connecting the first substrate to the second substrate, a mold structure on a top surface of the semiconductor chip, the lateral surface of the semiconductor chip, and a lateral surface of the wire, and an under-fill pattern on the lateral surface of the wire and is between the wire and the mold structure.

## Description

### BACKGROUND

The disclosure relates to a semiconductor package and a method of fabricating the same.

A semiconductor package is provided to implement an integrated circuit chip to qualify for use in electronic products. A semiconductor package is typically configured such that a semiconductor chip is mounted on a printed circuit board and bonding wires or bumps are used to electrically connect the semiconductor chip to the printed circuit board. With the development of electronic industry, various studies have been conducted to improve reliability and durability of semiconductor packages.

### SUMMARY

One or more example embodiments provide a semiconductor package with increased reliability and a method of fabricating a semiconductor package with increased reliability.

According to an aspect of an example embodiment, a semiconductor package, includes a first substrate; a semiconductor chip on the first substrate; a second substrate spaced apart from the first substrate; a wire spaced apart from a lateral surface of the semiconductor chip, wherein the wire connects the first substrate to the second substrate; a mold structure on a top surface of the semiconductor chip, the lateral surface of the semiconductor chip, and a lateral surface of the wire; and an under-fill pattern on the lateral surface of the wire and between the wire and the mold structure.

According to an aspect of an example embodiment, a semiconductor package, includes: a first sub-semiconductor package; and a second sub-semiconductor package on the first sub-semiconductor package, wherein the first sub-semiconductor package comprises: a lower substrate; a first semiconductor chip on the lower substrate; an upper substrate spaced apart from the lower substrate; a plurality of wires horizontally spaced apart from a lateral surface of the first semiconductor chip, wherein the wires vertically extend from the lower substrate toward the upper substrate; and a plurality of first under-fill patterns that cover lateral surfaces of the wires, wherein the first under-fill patterns are spaced apart from the first semiconductor chip.

According to an aspect of an example embodiment, a semiconductor package, includes: a first sub-package; and a second sub-package on the first sub-package, wherein the first sub-package comprises: a lower substrate; a first semiconductor chip and a plurality of wires on the lower substrate; at least one under-fill pattern that covers lateral surfaces of the wires; an upper substrate spaced apart from the lower substrate; and a first mold structure between the lower substrate and the upper substrate, wherein the first mold structure is disposed on top and lateral surfaces of the first semiconductor chip and a lateral surface of the under-fill pattern, wherein the second sub-package comprises: a package substrate; a second semiconductor chip on the package substrate; and a second mold structure on a top surface of the package substrate and top and lateral surfaces of the second semiconductor chip, wherein the top surface of the under-fill pattern is at a level higher than a level of a top surface of the first semiconductor chip.

According to an aspect of an example embodiment, a method of fabricating a semiconductor package includes: preparing a first substrate including first upper pads and second upper pads spaced apart from each other; attaching bonding wires onto corresponding first upper pads; forming under-fill patterns on the bonding wires; mounting on the first substrate a semiconductor chip to vertically overlap the second upper pads; and forming a mold structure on the under-fill patterns and the semiconductor chip.

At least some of the above and other features of the invention are set out in the claims.

### BRIEF DESCRIPTION OF DRAWINGS

The above and other aspects and features will be more apparent from the following description of example embodiments, taken in conjunction with the accompanying drawings, in which:
FIG. 1 illustrates a plan view showing a semiconductor package according to some embodiments of the present inventive concepts.
FIG. 2 illustrates a cross-sectional view taken along line I-I' of FIG. 1.
FIG. 3 illustrates an enlarged view showing section *aa* of FIG. 2.
FIG. 4 illustrates a plan view showing a semiconductor package according to some embodiments of the present inventive concepts.
FIG. 5 illustrates a cross-sectional view taken along line II-II' of FIG. 4.
FIG. 6 illustrates an enlarged view showing section *bb* of FIG. 5.
FIGS. 7A to 7L illustrate cross-sectional views showing a method of fabricating a semiconductor package according to some embodiments of the present inventive concepts.
FIGS. 8A to 8D illustrate cross-sectional views showing a method of fabricating a semiconductor package according to some embodiments of the present inventive concepts.

### DETAILED DESCRIPTION OF EMBODIMENTS

Example embodiments will be described more fully with reference to the accompanying drawings, in which example embodiments are shown. Embodiments described herein are provided as examples, and thus, the present disclosure is not limited thereto, and may be realized in various other forms. Each embodiment provided in the following description is not excluded from being associated with one or more features of another example or another embodiment also provided herein but consistent with the present disclosure. It will be understood that when an element or layer is referred to as being "on," "connected to" or "coupled to" another element or layer, it can be directly on, connected or coupled to the other element or layer, or intervening elements or layers may be present. By contrast, when an element is referred to as being "directly on," "directly connected to" or "directly coupled to" another element or layer, there are no intervening elements or layers present. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

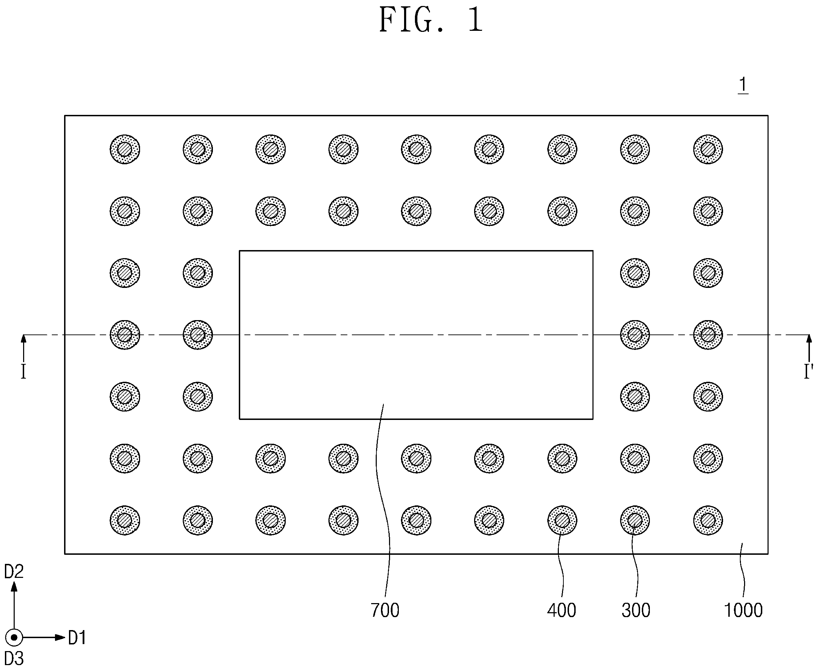

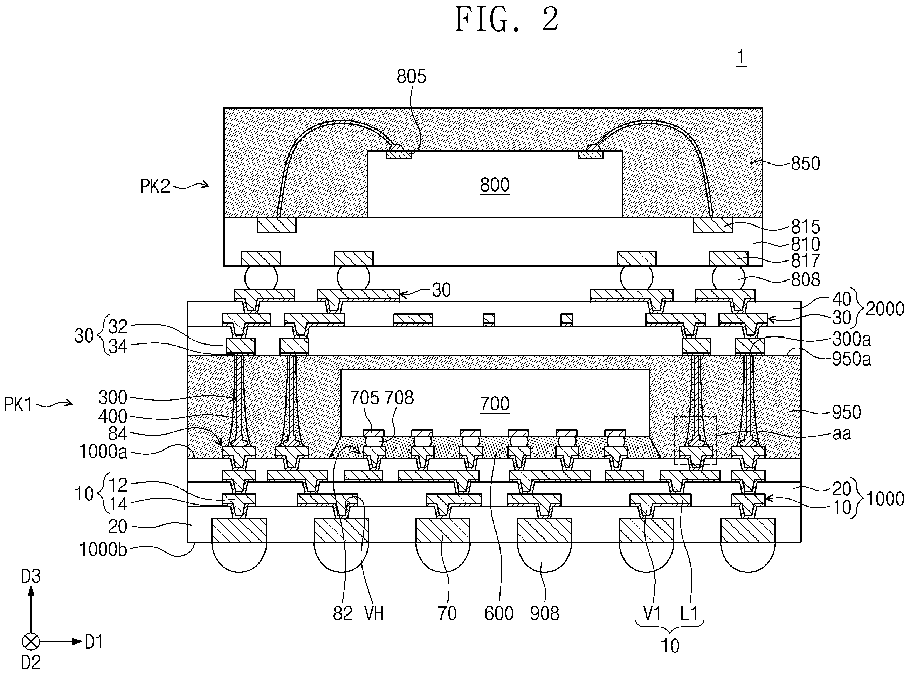

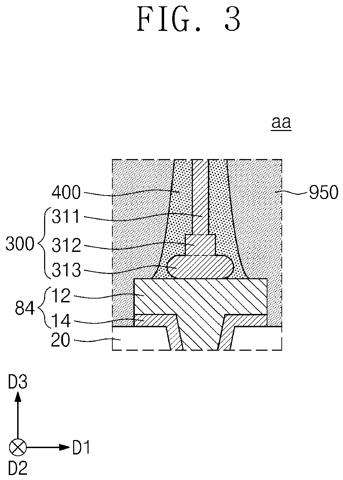

FIG. 1 illustrates a plan view showing a semiconductor package according to some embodiments. FIG. 2 illustrates a cross-sectional view taken along line I-I' of FIG. 1. FIG. 3 illustrates an enlarged view showing section *aa* of FIG. 2.

Referring to FIGS. 1 and 2, a semiconductor package 1 may include a first sub-semiconductor package PK1 and a second sub-semiconductor package PK2 on the first sub-semiconductor package PK1. The semiconductor package 1 may have a package-on-package structure.

The first sub-semiconductor package PK1 may include a first substrate 1000, a first semiconductor chip 700, a second substrate 2000, wires 300, and a first mold structure 950. The first substrate 1000 and the second substrate 2000 may be referred to as a lower substrate 1000 and an upper substrate 2000, respectively.

The first substrate 1000 may have a first surface 1000a and a second surface 1000b that faces the first surface 1000a so that the first surface 1000a and the second surface 1000b face each other. A first direction D1 is defined to refer to a direction parallel to the first surface 1000a of the first substrate 1000. A second direction D2 is defined to refer to a direction parallel to the first surface 1000a and perpendicular to the first direction D 1. A third direction D3 is defined to refer to a direction perpendicular to the first surface 1000a of the first substrate 1000.

The first substrate 1000 may be a printed circuit board (PCB) or a redistribution substrate.

When the first substrate 1000 is a redistribution substrate, as shown in FIG. 2, the first substrate 1000 may include first redistribution patterns 10, first dielectric layers 20, and under-bump patterns 70. The first redistribution patterns 10 and the under-bump patterns 70 may be disposed in the first dielectric layers 20. As shown in FIG. 2, in an embodiment, there may be multiple first dielectric layers 20. In other embodiments, different from that shown, the first dielectric layers 20 may be regarded as one dielectric layer. The first dielectric layer 20 may include a photo-imageable dielectric material. For example, the first dielectric layer 20 may include at least one selected from photosensitive polyimide, polybenzoxazole, phenolic polymers, and benzocyclobutene polymers.

The under-bump patterns 70 may be disposed on the second surface 1000b of the first substrate 1000. A bottom surface of each of the under-bump patterns 70 may be exposed from the first dielectric layer 20. The under-bump patterns 70 may include, for example, at least one of copper or aluminum.

The first redistribution patterns 10 may be stacked on the under-bump patterns 70. Each of the redistribution patterns 10 may include a first conductive pattern 12 and a first seed/barrier pattern 14. For example, the first conductive pattern 12 may include copper, and the first seed/barrier pattern 14 may include copper/titanium.

The first seed/barrier pattern 14 may be provided locally on a bottom surface of the first conductive pattern 12. Each of the first redistribution patterns 10 may include a via portion V1 and a line portion L1 that are connected to form a single unitary piece. The via portion V1 of the first redistribution pattern 10 may fill a via hole VH of the first dielectric layer 20, and may be connected to the under-bump pattern 70 or the line portion L1 of another first redistribution pattern 10 that underlies the first redistribution pattern 10.

First upper pads 82 and second upper pads 84 may be provided on uppermost ones of the first redistribution patterns 10. The first upper pads 82 and the second upper pads 84 may have configurations that are substantially the same as that of the first redistribution patterns 10. For example, each of the first and second upper pads 82 and 84 may include the first conductive pattern 12 and the first seed/barrier pattern 14.

The first semiconductor chip 700 may be provided on the first substrate 1000. The first semiconductor chip 700 may be, for example, a logic chip or a memory chip such as DRAM or NAND Flash. The first semiconductor chip 700 may be disposed on the first substrate 1000 to allow a first chip pad 705 of the first semiconductor chip 700 to face the first substrate 1000.

A connection terminal 708 may contact and be electrically connected to the first upper pad 82 and the first chip pad 705. The first semiconductor chip 700 may be electrically connected to the connection terminal 708 and is electrically connected to the first substrate 1000 through the connection terminal 708. The connection terminal 708 may include at least one selected from a solder, a pillar, and a bump. The connection terminal 708 may include a conductive material, such as tin (Sn) or silver (Ag).

The wires 300 may be disposed on the first surface 1000a of the first substrate 1000 and spaced apart from a lateral surface of the first semiconductor chip 700. An under-fill pattern 400 may be disposed on and cover a lateral surface of the wire 300. The wire 300 may be referred to as a bonding wire 300. The under-fill pattern 400 may be referred to as the first under-fill pattern 400. The wire 300 and the first under-fill pattern 400 will be further discussed in detail below.

The second substrate 2000 may be disposed on a top surface 950a of the first mold structure 950, a top surface 300a of the wire 300, and a top surface of the first under-fill pattern 400. The second substrate 2000 may be a redistribution substrate.

The second substrate 2000 may include a second dielectric layer 40 and a second redistribution pattern 30. The second dielectric layer 40 may be a photo-imageable dielectric layer the same as or similar to the first dielectric layer 40. The second redistribution pattern 30 may include a second conductive pattern 32 and a second seed/barrier pattern 34. The second conductive pattern 32 and the second seed/barrier pattern 34 may include materials identical or similar to those of the first conductive pattern 12 and the first seed/barrier pattern 14, respectively. Like the first redistribution pattern 10, the second redistribution pattern 30 may have a via portion V1 and a line portion L1 connected to the via portion V1.

The second sub-semiconductor package PK2 may be provided on the second substrate 2000. The second sub-semiconductor package PK2 may include a package substrate 810, a second semiconductor chip 800, and a second mold structure 850. The package substrate 810 may be a printed circuit board or a redistribution substrate. The package substrate 810 may be provided with metal pads 815 and 817 on opposite surfaces thereof. The second semiconductor chip 800 may be, for example, a memory chip or a logic chip. The second semiconductor chip 800 may be of a different type from the first semiconductor chip 700. For example, the second semiconductor chip 800 may have on its one surface a second chip pad 805 that is wire-bonded to the metal pad 815 of the package substrate 810.

A package bonding terminal 808 may be disposed between the first sub-semiconductor package PK1 and the second sub-semiconductor package PK2. The package bonding terminal 808 may be in contact with the metal pad 817 and an uppermost one of the second redistribution patterns 30. The package bonding terminal 808 may be electrically connected to the second redistribution pattern 30 and the metal pad 817. Therefore, the second sub-semiconductor package PK2 may be electrically connected to the first semiconductor chip 700 and an external bonding terminal 908 through the package bonding terminal 808, the second substrate 2000, the wire 300, and the first substrate 1000.

The wires 300 may connect the first substrate 1000 to the second substrate 2000. The wires 300 may be arranged such that they are spaced apart from each other along the first direction D1 and the second direction D2. The wires 300 may be disposed on the second upper pads 84. Each of the wires 300 may extend along the third direction D3.

The wire 300 may include a metallic material. The wire 300 may include, for example, at least one selected from gold, silver, copper, and aluminum. As shown in FIG. 3, the wire 300 may include a first portion 311, a second portion 312, and a third portion 313. The second portion 312 may be interposed between the first portion 311 and the third portion 313. According to some embodiments, the second portion 312 may be omitted, and the first portion 311 and the third portion 312 may be directly connected to each other. When viewed in vertical section, the first portion 311 may have a linear shape whose length is about 10 times greater than a width, and the second portion 312 may have a rectangular or square shape. In an embodiment, the first portion 311 may have a linear shape whose length is 10 times or greater than a width. The third portion 313 may have a hemispherical or almost hemispherical shape.

A length in the third direction D3 of the first portion 311 may be greater than a length in the third direction D3 of the second portion 312 and a length in the third direction D3 of the third portion 313. The length in the third direction D3 of the first portion 311 may be greater than a sum of the lengths in the third direction D3 of the second and third portions 312 and 313.

The first portion 311, the second portion 312, and the third portion 313 may respectively have a first diameter, a second diameter, and a third diameter in the first direction D1. The third diameter may be greater than the second diameter, and the second diameter may be greater than the first diameter. The first diameter may be substantially constant along the third direction D3. The third diameter may have a maximum around substantially a center of the third portion 313 in the third direction D3. In an embodiment, the third diameter may decrease along the third direction D3 away from the vertical center. For example, in an embodiment, the third diameter may decrease along the third direction D3 that is vertically away from the first surface 1000a of the first substrate 1000.

The first under-fill pattern 400 may include a dielectric material. The first under-fill pattern 400 may include, for example, an epoxy resin.

The first under-fill patterns 400 may be spaced apart from each other while being in one-to-one contact with the wires 300. The first under-fill pattern 400 may expose the top surface 300a of the wire 300 while being disposed on and covering the lateral surface of the wire 300. As shown in FIG. 3, the first under-fill pattern 400 may be in contact with a lateral surface of the first portion 312, a lateral surface of the third portion 313, and a top surface of the second upper pad 84. A distance between opposite lateral surfaces, or a width in the first direction D1, of the first under-fill pattern 400 may increase in a direction from the first portion 311 toward the third portion 313.

An interface may be provided between the first under-fill pattern 400 and the first mold structure 950. The first under-fill pattern 400 and the first mold structure 950 may each include epoxy resin and silica (SiO₂). The first under-fill pattern 400 and the first mold structure 950 may further include different materials other than epoxy resin and silica. For example, unlike the first under-fill pattern 400, the first mold structure 950 may further include carbon a black and/or a release agent.

The first under-fill pattern 400 may be not in contact with the first semiconductor chip 700. The first under-fill pattern 400 may be spaced apart from an active surface on which are disposed the first chip pads 705 of the first semiconductor chip 700.

A second under-fill pattern 600 (see FIG. 2) may be interposed between the active surface of the first semiconductor chip 700 and the first surface 1000a of the first substrate 1000. The second under-fill pattern 600 may be disposed on and cover a lateral surface of the connection terminal 708. According to some embodiments, the second under-fill pattern 600 may include the same material as that of the first under-fill pattern 400. The first under-fill pattern 400 and the second under-fill pattern 600 may be spaced apart from each other. According to some embodiments, the second under-fill pattern 600 may be omitted. In this case, the first mold structure 950 may be disposed on and cover the lateral surface of the connection terminal 708 while filling a space between the first substrate 1000 and the active surface of the first semiconductor chip 700.

Referring back to FIGS. 1 and 2, the top surface 300a of the wire 300 may be exposed from the top surface 950a of the first mold structure 950. In addition, the top surface 300a of the wire 300 may be exposed from the top surface of the first under-fill pattern 400. There may be coplanarity between the top surface 950a of the first mold structure 950, the top surface 300a of the wire 300, and the top surface of the first under-fill pattern 400. The top surface 300a of the wire 300 may be located at substantially the same level as that of the top surface of the first under-fill pattern 400. The wire 300 may have a height substantially the same as that of the first under-fill pattern 400. The height of each of the wire 300 and the first under-fill pattern 400 may indicate a length in the third direction D3 from the top surface of the second upper pad 84.

As shown in FIG. 1, the wire 300 may have a circular or almost circular shape at the top surface 300a exposed from the first mold structure 950. The first under-fill pattern 400 may have a ring shape at the exposed top surface thereof.

In an embodiment, to improve thermal radiation properties of the semiconductor package 1 or the first sub-semiconductor package PK1, the first semiconductor chip 700 may have a thickness equal to or greater than a certain value. In this case, there may be a connection means through which the lower substrate 1000 and the upper substrate 2000 are connected to each other and the connection means may be formed to have a height greater than the thickness of the first semiconductor chip 700. In the present inventive concepts, the wire 300 may be used as the connection means, and by using a wire 300 it may be easy to increase a height of the connection means. In addition, an under-fill may be employed to reinforce stiffness of wires, and thus a semiconductor package may increase in reliability. Further, the wires may be formed to have a fine pitch therebetween (for example, a small centre-to-centre distance between the wires), and thus it may be possible to arrange the wires at fine pitches.

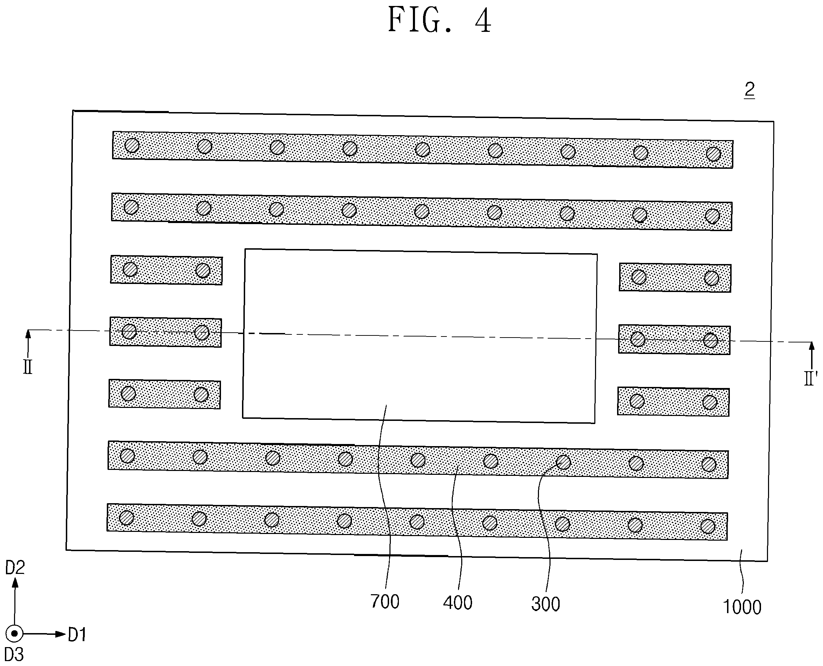

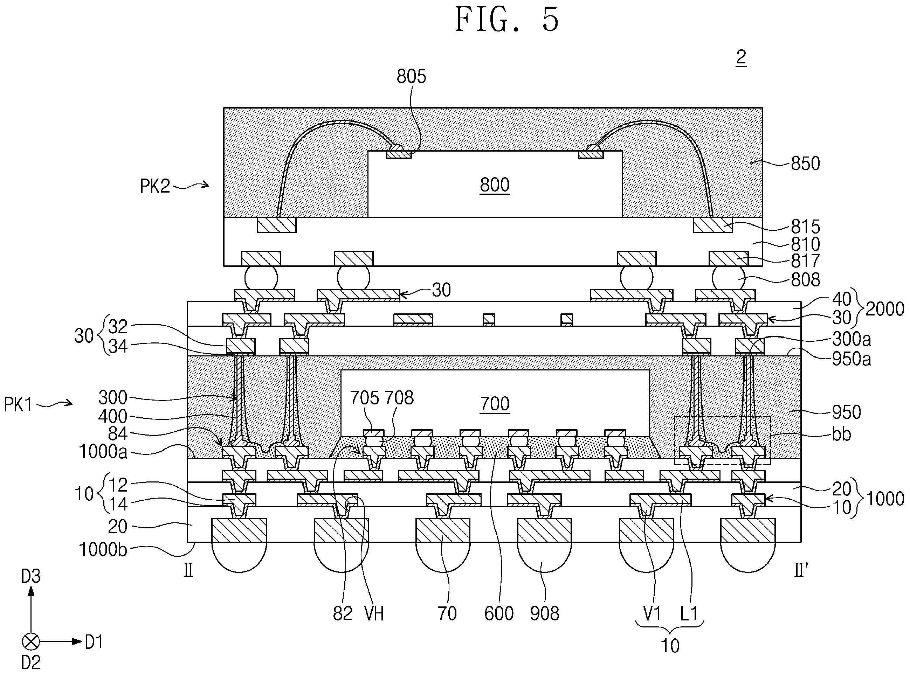

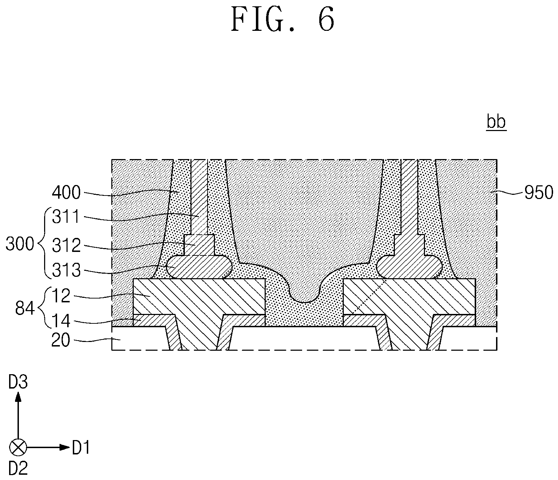

FIG. 4 illustrates a plan view showing a semiconductor package according to some embodiments. FIG. 5 illustrates a cross-sectional view taken along line II-II' of FIG. 4. FIG. 6 illustrates an enlarged view showing section *bb* of FIG. 5. Except for the following explanation, a description duplicate to those discussed with reference to FIGS. 1 to 3 will be omitted.

Referring to FIGS. 4 and 5, a semiconductor package 2 may be provided in which the first under-fill patterns 400 may each extend along the first direction D1, and in which the first under-fill patterns 400 may be spaced apart from each other along the second direction D2. When viewed in plan, each of the first under-fill patterns 400 may have a linear shape that extends along the first direction D1. A single first under-fill pattern 400 may be in contact with the lateral surfaces of a plurality of wires 300 that are adjacent to each other along the first direction D1. For example, the under-fill pattern 400 may be in one-to-many contact with the wires 300.

Referring to FIG. 6, the first under-fill pattern 400 may fill at least a portion of a gap between neighboring second upper pads 84. The first under-fill pattern 400 may be in contact with a lateral surface of the second upper pad 84. The first under-fill pattern 400 may be in contact with an uppermost first dielectric layer 20 of the first substrate 1000.

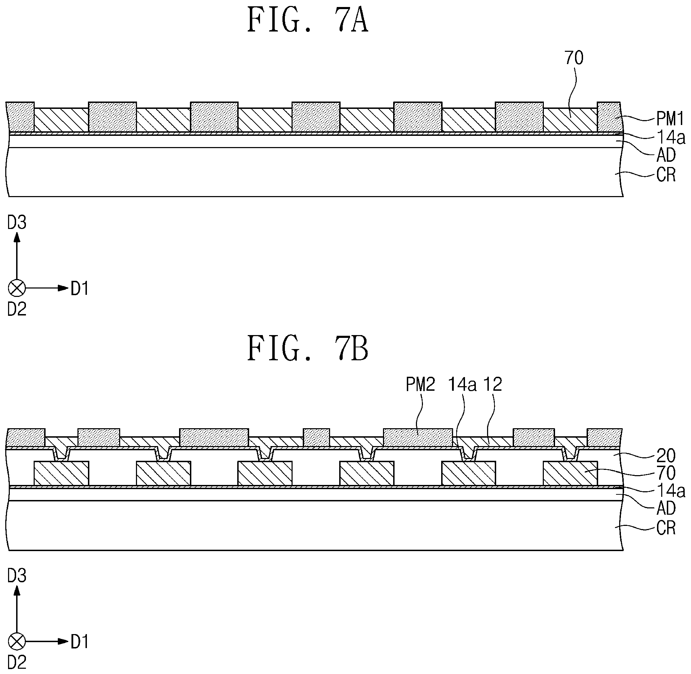

FIGS. 7A to 7L illustrate cross-sectional views showing a method of fabricating a semiconductor package according to some embodiments.

Referring to FIG. 7A, a carrier substrate CR may be provided which has an adhesion layer AD formed on one surface thereof. A seed/barrier layer 14a may be formed on the carrier substrate CR to cover a top surface of the adhesion layer AD. The seed/barrier layer 14a may be formed by a deposition process. For example, the seed/barrier layer 14a may include copper/titanium (Cu/Ti). The adhesion layer AD may attach the seed/barrier layer 14a to a top surface of the carrier substrate CR.

A first photomask pattern PM1 may be formed on a top surface of the seed/barrier layer 14a. The first photomask pattern PM1 may include an opening that defines a space in which an under-bump pattern 70 is formed. The first photomask pattern PM1 may be formed by forming, exposing, and developing a photoresist layer. The first photomask pattern PM1 may expose a portion of the seed/barrier layer 14a. The under-bump pattern 70 may be formed in the opening by performing an electroplating process in which the seed/barrier layer 14a is used as an electrode.

Referring to FIG. 7B, the first photomask pattern PM1 may be removed. A first dielectric layer 20 may be formed to cover the under-bump pattern 70. The first dielectric layer 20 may be formed by a process such as spin coating, and then exposure and development processes may be performed to pattern the first dielectric layer 20 to have an opening that exposes a top surface of the under-bump pattern 70. Afterwards, a curing process may be performed on the first dielectric layer 20. A seed/barrier layer 14a may be formed again on the first dielectric layer 20. A second photomask pattern PM2 including openings may be formed on the seed/barrier layer 14a. An electroplating process may be performed in which the seed/barrier layer 14a is used as an electrode to form a first conductive pattern 12 on the seed/barrier layer 14a.

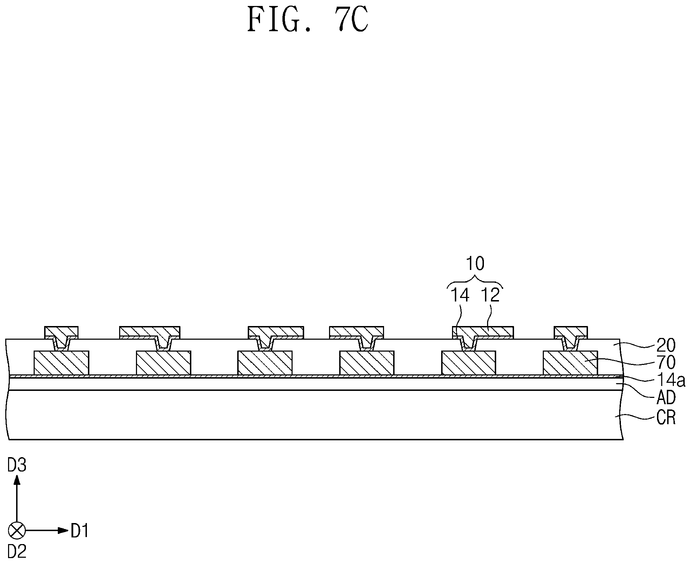

Referring to FIG. 7C, the second photomask pattern PM2 may be removed. A first seed/barrier pattern 14 may be formed by removing the seed/barrier layer 14a on an area exposed from the first conductive pattern 12. A first redistribution pattern 10 may be formed which includes the first conductive pattern 12 and the first seed/barrier pattern 14.

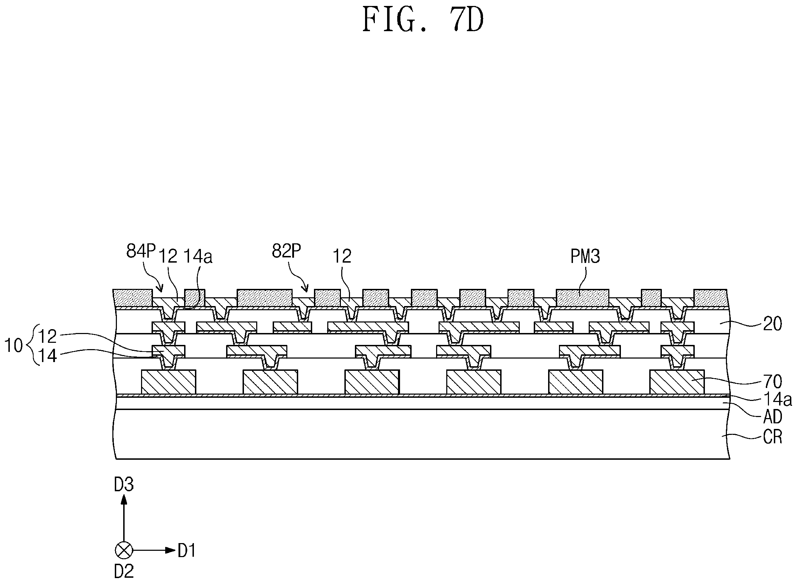

Referring to FIG. 7D, similarly to the method for forming the first dielectric layer 20 and the first redistribution pattern 10, another first dielectric layer 20 and another first redistribution pattern 10 may be sequentially and repeatedly stacked. After uppermost first redistribution patterns 10 are stacked, a first dielectric layer 20 may be formed to partially expose the uppermost first redistribution patterns 10. The uppermost first dielectric layer 20 may be formed by spin coating, exposure, development, and curing processes. A seed/barrier layer 14a may be formed on the uppermost first dielectric layer 20. After that, a third photomask pattern PM3 may be formed which includes openings. An electroplating process may be performed in which the seed/barrier layer 14a is used as an electrode to form a first conductive pattern 12 on the seed/barrier layer 14a. The seed/barrier layer 14a and the first conductive patterns 12 may constitute first preliminary upper pads 82P and second preliminary upper pads 84P.

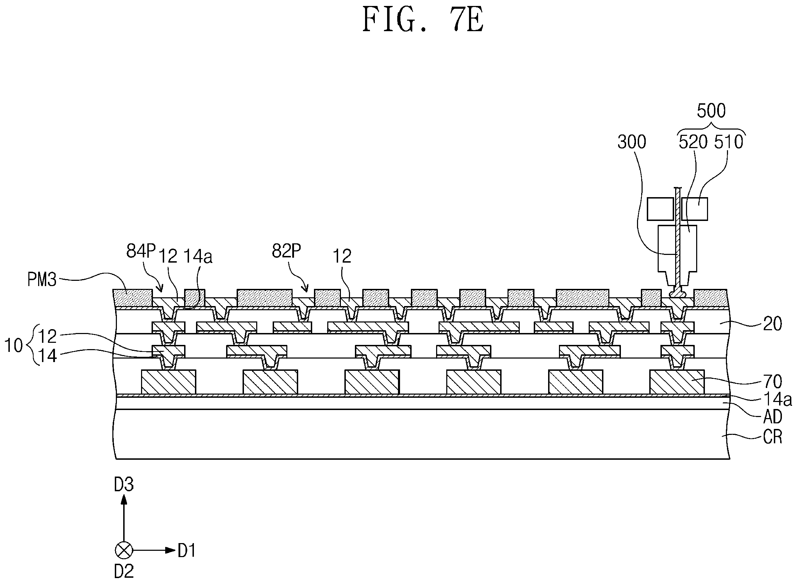

Referring to FIG. 7E, a wire bonding process may be performed. A wire 300 may be disposed on the second preliminary upper pad 84P. A wire control machine 500 capable of moving and adjusting length may be used to place the wire 300 on the second preliminary upper pad 84P.

The wire control machine 500 may include a wire spool, a wire tensioner system, a wire clamp 510, a capillary 520, and an electric-flame-off (EPO). The wire control machine 500 may be a typical wire control machine.

The wire 300 may include a line portion with a large length and a bonding portion with a small length and large width. The wire 300 may pass through the capillary 520 to form a tail that slightly protrudes from the capillary 520, and thus the bonding portion may be exposed from the capillary 520. The EPO may provide the bonding portion with a spark to form a ball-shape portion on an end of the bonding portion.

The ball-shape portion of the wire 300 may be attached to a top surface of the second preliminary upper pad 84P and an external force may be applied. A shape of the ball-shape portion may be adjusted by a combination of external force, heat, and/or supersonic wave. The capillary 510 may be used again to adjust a length of the wire 300, and then the wire 300 may be cut. Accordingly, the line portion, the bonding portion, and the ball-shape portion may be respectively formed into the first portion 311, the second portion 312, and the third portion 313 of FIG. 3.

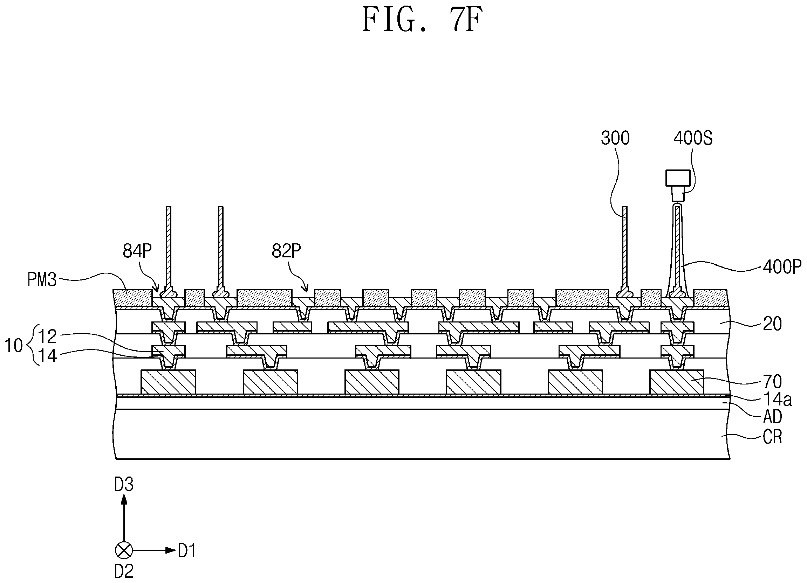

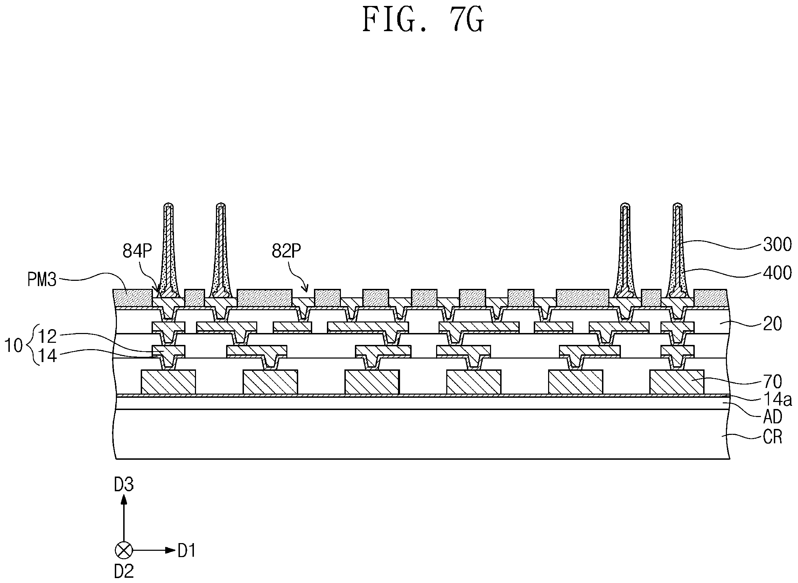

Referring to FIGS. 7F and 7G, each of the wires 300 may be provided thereon with a non-cured under-fill material 400P to be disposed on and cover top and lateral surfaces of the wire 300. The under-fill material 400P may be introduced or flowed from a nozzle 400S, and a flow rate may be adjusted by a diameter of the nozzle 400S. The under-fill material 400P may be individually introduced to each of the wires 300.

Thereafter, as shown in FIG. 7G, the under-fill material 400P may be cured to form a first under-fill pattern 400.

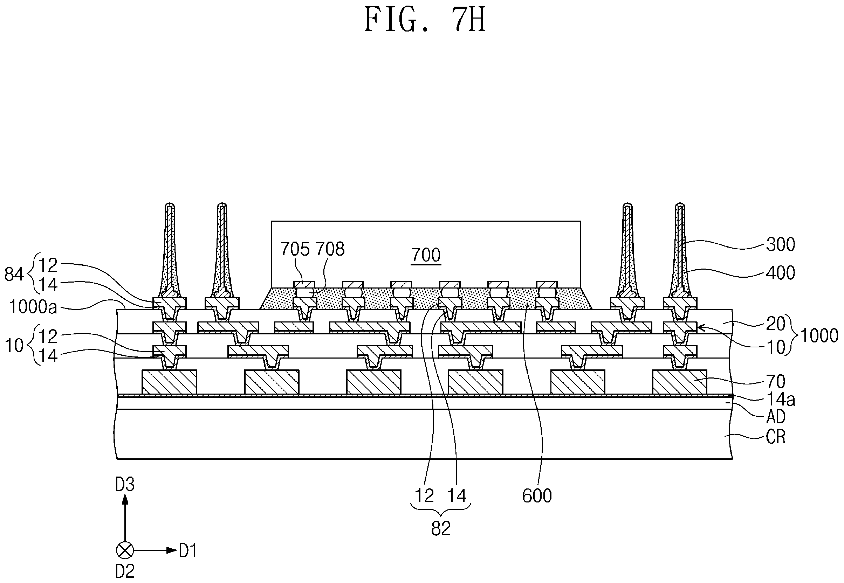

Referring to FIG. 7H, the third photomask pattern MP3 may be removed. Afterwards, a first seed/barrier pattern 14 may be formed by removing the seed/barrier layer 14a that does not overlap the first conductive patterns 12. Therefore, the first preliminary upper pad 82P and the second preliminary upper pad 84P may be formed into a first upper pad 82 and a second upper pad 84, respectively. At the same time, a first substrate 1000 may also be formed.

A first semiconductor chip 700 may be mounted on the first substrate 1000 to allow a first chip pad 705 of the first semiconductor chip 700 to face the first substrate 1000. A thermocompression process may be performed to place the first semiconductor chip 700 on the first substrate 1000. The first upper pads 82 may be correspondingly attached thereto with connection terminals 708 adhered to the first chip pads 705. A second under-fill pattern 600 may be formed by introducing and curing an under-fill material. According to some embodiments, the formation of the second under-fill pattern 600 may be omitted.

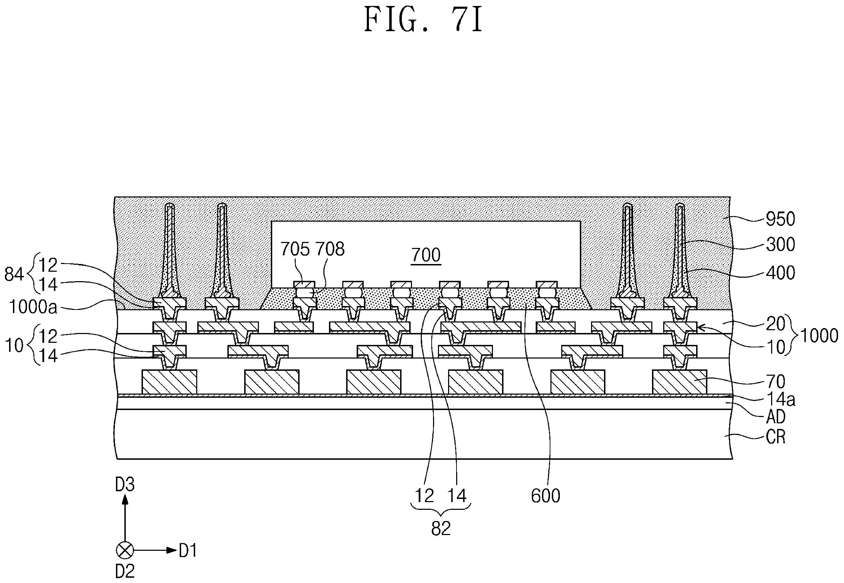

Referring to FIG. 7I, a first mold structure 950 may be formed to cover top and lateral surfaces of the first under-fill pattern 400, a first surface 1000a of the first substrate 1000, and top and lateral surfaces of the first semiconductor chip 700. The first mold structure 950 may be formed by introducing and curing a molding material in a melted state. The molding material may include, for example, a melted epoxy molding compound (EMC).

According to embodiments, when the molding material is introduced, the under-fill pattern 400 may fix the wire 300. Thus, even when the molding material is introduced, the wire 300 may be prevented from being swept, and even after the introduction of the molding material, the wire 300 may maintain its shape extending in the third direction D3 without being inclined.

When the formation of the second under-fill pattern 600 is omitted, a first mold structure 950 may be formed to be disposed on and cover a first surface 1000a and top and lateral surfaces of the first semiconductor chip 700 and to fill a space between a bottom surface of the first semiconductor chip 700 and the first surface 1000a of the first substrate 1000. The first mold structure 950 may be formed to encapsulate the wire 300 and the first under-fill pattern 400.

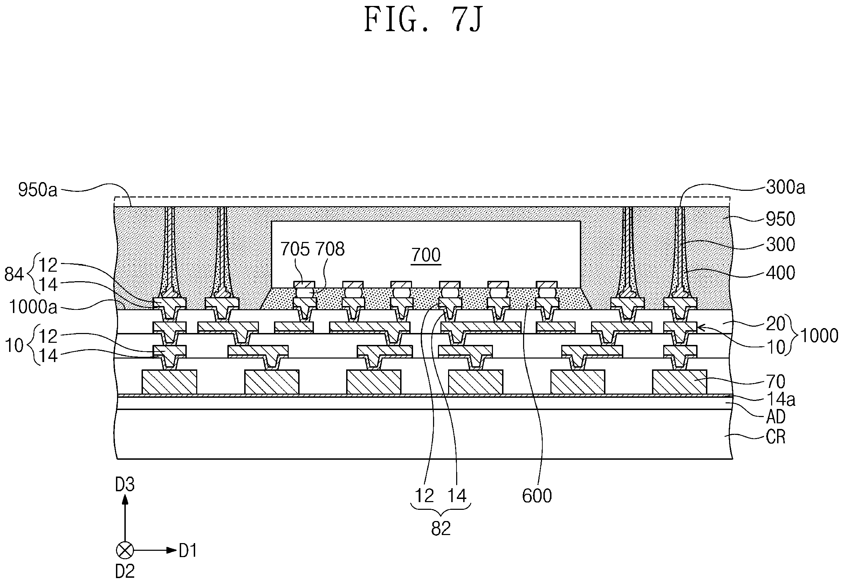

Referring to FIG. 7J, a planarization process may be performed on the first mold structure 950. The planarization process may continue until a top surface 300a of the wire 300 is exposed. As result of the planarization process, there may be coplanarity between a top surface 950a of the first mold structure 950, the top surface 300a of the wire 300, and the top surface of the first under-fill pattern 400.

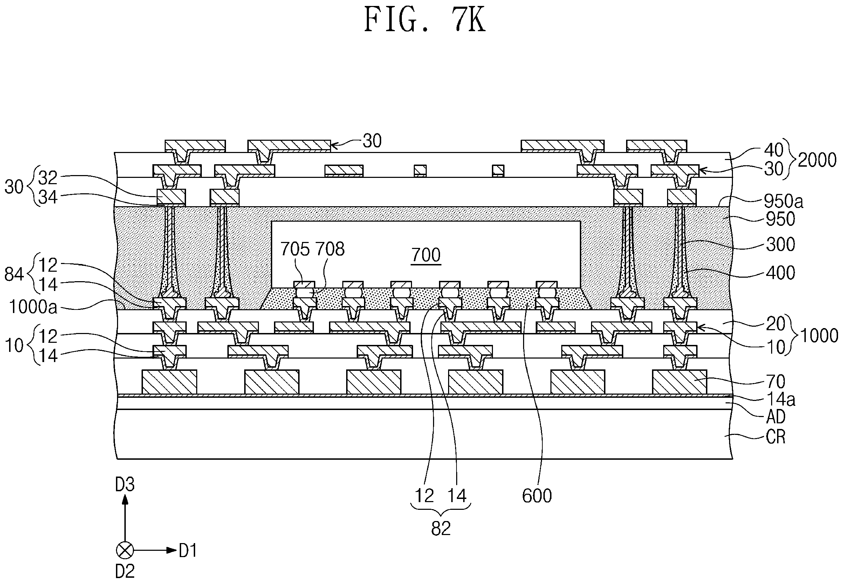

Referring to FIG. 7K, a second substrate 2000 may be formed on the first mold structure 950 and the wire 300. The second substrate 2000 may be formed by a method substantially the same as that used for forming the first substrate 1000. A second redistribution pattern 30 may be formed to connect with the wire 300.

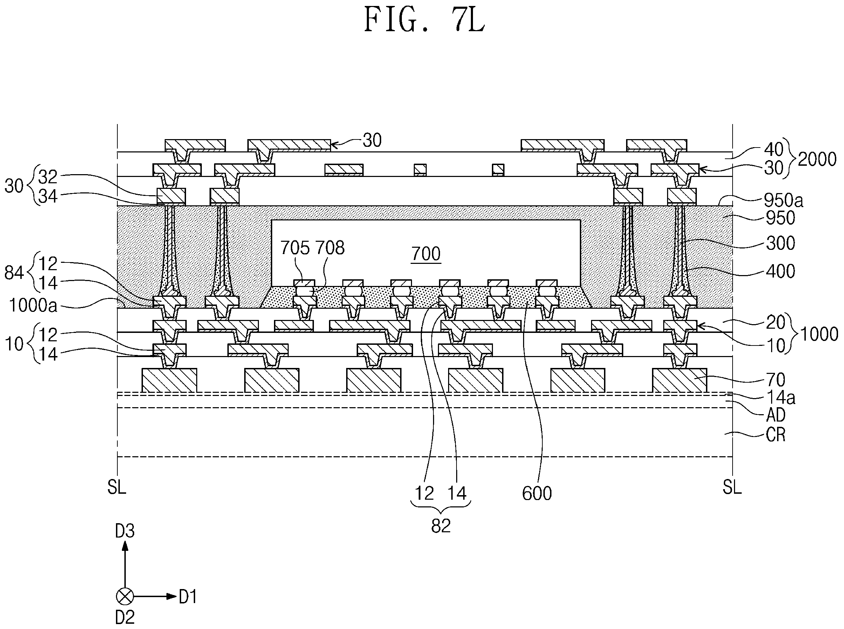

Referring to FIG. 7L, a singulation process takes place along a sawing line SL in the third direction D3. After that, the carrier substrate CR, the adhesion layer AD, and the seed/barrier layer 14a may be removed. An etching process may be performed to remove the seed/barrier layer 14a. The removal of the seed/barrier layer 14a may expose the under-bump patterns 70.

Referring back to FIG. 2, external bonding terminals 908 may be formed on the exposed under-bump patterns 70, and thus a first sub-semiconductor package PK1 may be formed. A second sub-semiconductor package PK2 may be mounted on the first sub-semiconductor package PK1. Accordingly, a semiconductor package 1 may be fabricated to have a package-on-package structure in which the second sub-semiconductor package PK2 is stacked on the first sub-semiconductor package PK1.

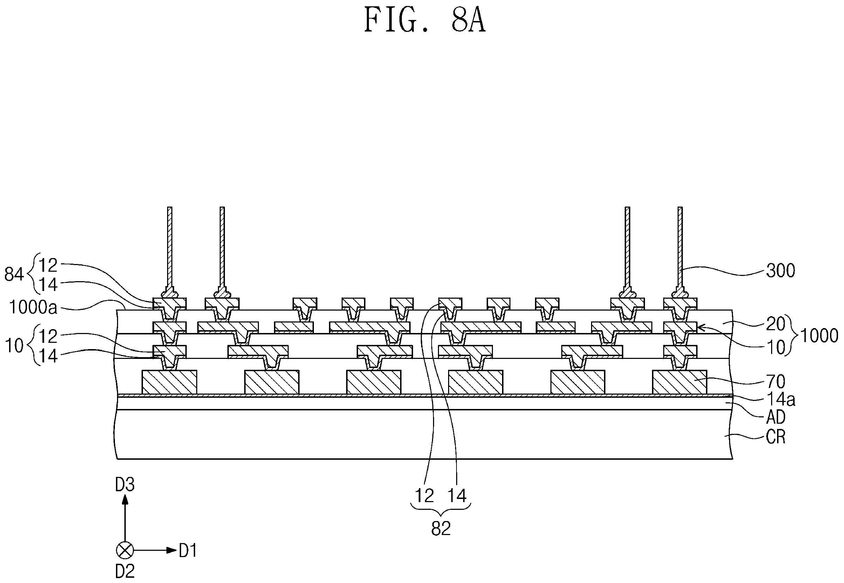

FIGS. 8A to 8D illustrate cross-sectional views showing a method of fabricating a semiconductor package according to some embodiments.

Referring to FIGS. 7E and 8A, after the wire bonding process, the third photomask pattern PM3 may be removed. Afterwards, a first seed/barrier pattern 14 may be formed by removing the seed/barrier layer 14a that does not overlap the first conductive patterns 12. At the same time, formed a first upper pad 82, a second upper pad 84, and a first substrate 1000 may be formed.

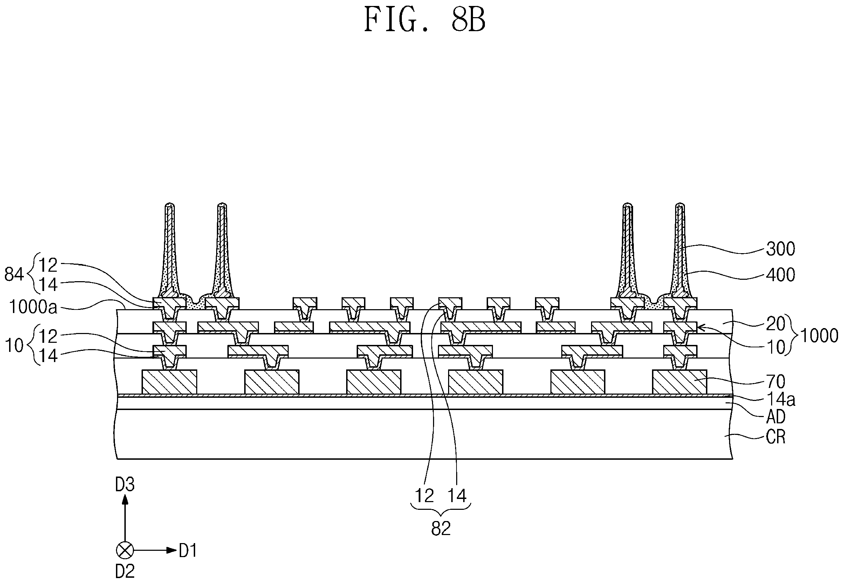

Referring to FIG. 8B, one first under-fill pattern 400 may be formed to be disposed on and cover a plurality of wires 300. An under-fill material may be introduced along the first direction D1 to form the first under-fill pattern 400 having a linear shape (see FIG. 4). In this embodiment, the first under-fill patterns 400 may be formed at a higher speed than that at which the first under-fill pattern 400 is formed on each of the wires 300 in the aforementioned case. In an embodiment where the first under-fill pattern 400 is formed on each of the wires 300, compared to this case, the lateral surface of the wire 300 may be finely covered (see FIG. 7G).

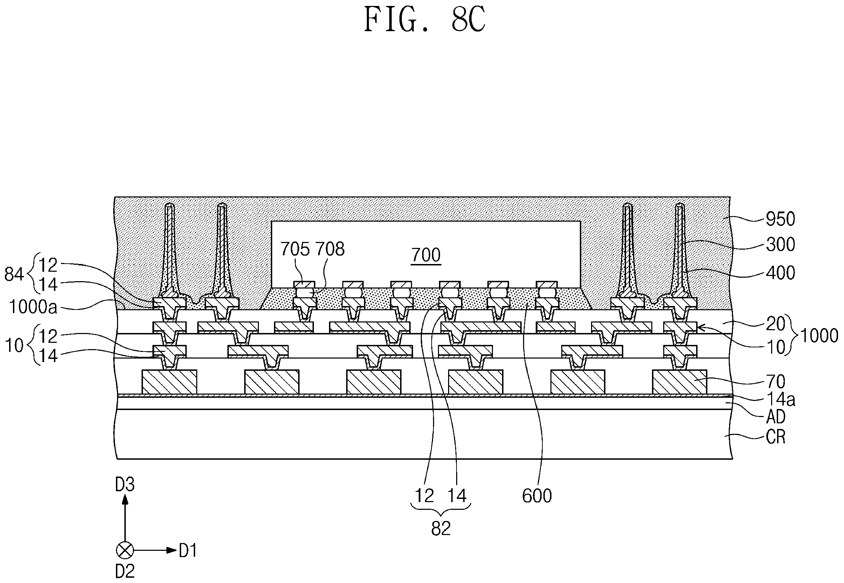

Referring to FIG. 8C, a first semiconductor chip 700 may be mounted on the first substrate 1000. A second under-fill pattern 600 may be formed by performing introducing and curing an under-fill material, but according to some embodiments, the formation of the second under-fill pattern 600 may be omitted. A first mold structure 950 may be formed to cover top and lateral surfaces of the first under-fill pattern 400, a first surface 1000a of the first substrate 1000, and top and lateral surfaces of the first semiconductor chip 700.

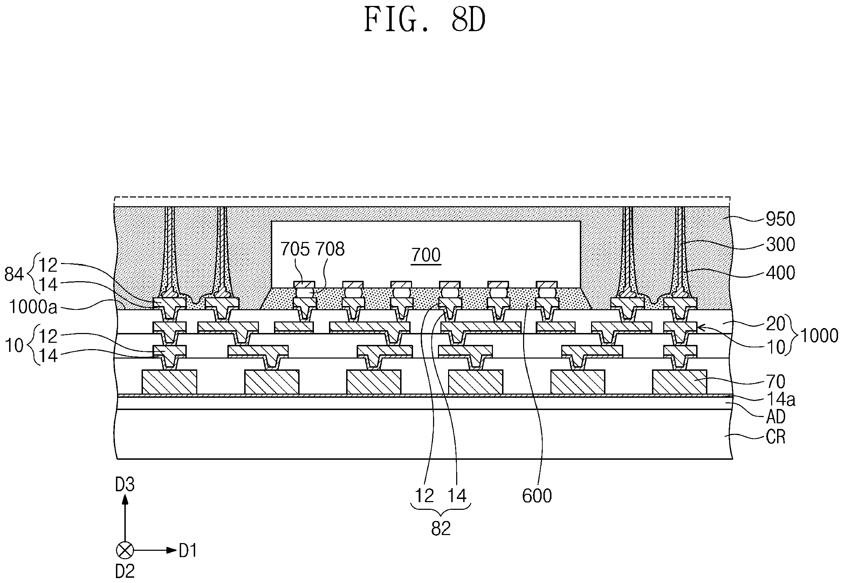

Referring to FIG. 8D, the first mold structure 950 may undergo a planarization process until the wire 300 is exposed. Therefore, the first mold structure 950, the wire 300, and the first under-fill pattern 400 may have their top surfaces substantially coplanar with each other.

Subsequent processes may be the same as those discussed with reference to FIG. 7K, 8L, and 2, and as a result, a semiconductor package 2 may be fabricated as shown in FIG. 5.

When a vertical conductive structure is formed as a connection means through which a first substrate and a second substrate are connected to each other, it may be difficult to increase a height of the vertical conductive structure. For example, when an electroplating process is used to form the vertical conductive structure, more than two-layered photoresist pattern may be needed to form a deep opening. Therefore, the formation of the vertical conductive structure may consume much time and incur a cost increase.

Embodiments may use a wire instead of the vertical conductive structure. As it may be easy to increase a height of a wire and a wire does not need an electroplating process, it may not be required to use a multi-layered photoresist layer. For example, an under-fill material may be introduced onto the wire and then cured, and thus even when a molding material is provided, the wire may not be swept. As a result, when a second substrate is formed, the wire and a lower pad of the second substrate may be satisfactorily connected to each other without being misaligned.

A semiconductor package according to embodiments may have a package-on-package (POP) structure. A first sub-package positioned at a bottom side may use a wire as a connection means for connection between a lower substrate and an upper substrate. A plurality of wires may be arranged not only to have easy control over heights thereof, but to have fine pitches therebetween. When a semiconductor chip in the semiconductor package has an increase in thickness to improve thermal radiation properties, it may be easy to increase a height of the wire. In addition an under-fill pattern may be provided between the wire and a mold structure. The under-fill pattern may be in contact with the wire. The under-fill pattern may reinforce stiffness of the wire, and thus the wire may maintain its shape extending in a vertical direction without being swept when the mold structure is formed. As a result, the wires may be prevented from being in contact with each other (reduction in short-circuit risk). In addition, when the upper substrate is formed on the wires, there may be a reduction in misalignment between the upper substrate and the wire. Accordingly, in an embodiment, it may be possible to increase reliability of a semiconductor package and its fabrication process.

While aspects of example embodiments have been particularly shown and described, it will be understood that various changes in form and details may be made therein without departing from the scope of the following claims.

## Claims

1. A semiconductor package, comprising:
a first substrate;
a semiconductor chip on the first substrate;
a second substrate spaced apart from the first substrate;
a wire spaced apart from a lateral surface of the semiconductor chip, wherein the wire connects the first substrate to the second substrate;
a mold structure on a top surface of the semiconductor chip, the lateral surface of the semiconductor chip, and a lateral surface of the wire; and
an under-fill pattern on the lateral surface of the wire and between the wire and the mold structure.

2. The semiconductor package of claim 1, wherein the wire comprises at least one of silver, gold, and aluminum.

3. The semiconductor package of claim 1 or 2, wherein:
the first substrate comprises an upper pad on a top surface of the first substrate, and
the under-fill pattern contacts the upper pad.

4. The semiconductor package of any preceding claim, wherein:
when viewed in plan, the under-fill pattern has a ring shape around the under-fill pattern, and
a top surface of the wire is exposed from the under-fill pattern.

5. The semiconductor package of any preceding claim 1, wherein:
the under-fill pattern has a first width in a first direction parallel to a top surface of the first substrate, and
the first width increases with decreasing distance from the first substrate.

6. The semiconductor package of any preceding claim, wherein a top surface of the wire, a top surface of the under-fill pattern, and a top surface of the mold structure are coplanar.

7. The semiconductor package of any preceding claim, wherein:
the first substrate comprises a printed circuit board, PCB, and
the second substrate comprises a redistribution substrate.

8. The semiconductor package of any one of claims 1 to 6, wherein each of the first substrate and the second substrate comprises a redistribution substrate.

9. A semiconductor package, comprising:
a first sub-semiconductor package; and
a second sub-semiconductor package on the first sub-semiconductor package,
wherein the first sub-semiconductor package comprises:
a lower substrate;
a first semiconductor chip on the lower substrate;
an upper substrate spaced apart from the lower substrate;
a plurality of wires horizontally spaced apart from a lateral surface of the first semiconductor chip, wherein the wires vertically extend from the lower substrate toward the upper substrate; and
a plurality of first under-fill patterns that cover lateral surfaces of the wires,
wherein the first under-fill patterns are spaced apart from the first semiconductor chip.

10. The semiconductor package of claim 9, wherein:
the wires are disposed along a first direction and a second direction that are parallel to a top surface of the lower substrate, wherein the second direction intersects the first direction,
each of the first under-fill patterns extends along the first direction to contact at least one of the wires, and
the first under-fill patterns are spaced apart from each other along the second direction.

11. The semiconductor package of claim 10 or 11, wherein, when viewed in plan, each of the first under-fill patterns has a linear shape that extends along the first direction.

12. The semiconductor package of claims 9 or 10, wherein each of the first under-fill patterns has a ring shape when viewed in plan.

13. The semiconductor package of any of claims 9 to 12, wherein the first sub-semiconductor package further comprises:
a plurality of connection terminals on an active surface of the first semiconductor chip; and
a second under-fill pattern that covers lateral surfaces of the connection terminals,
wherein the first under-fill pattern and the second under-fill pattern are spaced apart from each other.

14. The semiconductor package of any of claims 9 to 13, wherein:
each of the wires includes a first portion, a second portion, and a third portion,
the second portion is between the first portion and the third portion, and
a height of the first portion is greater than a sum of a height of the second portion and a height of the third portion.

15. The semiconductor package of claim 14, wherein:
the first portion has a first diameter, the second portion has a second diameter, and the third portion has a third diameter,
the third diameter is greater than the second diameter, and
the second diameter is greater than the first diameter.
